# EUROPÄISCHE PATENTSCHRIFT

(11) **EP 0 867 926 B1**
(45) Veröffentlichungstag und Bekanntmachung des Hinweises auf die Patenterteilung: **16.05.2007**
(21) Anmeldenummer: 98104834.1
(22) Anmeldetag: 17.03.1998
(51) Int. Cl.: H01L 21/3205, H01L 21/768

(54) **Herstellverfahren für eine Kondensatorelektrode aus einem Platinmetall**
Capacitor electrode made of platinum metal
Electrode d'un condensateur à base d'un métal du groupe de platine

(30) Priorität: 25.03.1997 DE 19712540
(43) Veröffentlichungstag der Anmeldung: 30.09.1998
(73) Patentinhaber: Qimonda AG, 81739 München (DE)
(72) Erfinder: Schindler, Günther, Dr., 80802 München (DE); Hartner, Walter, 81829 München (DE); Weinrich, Volker, Dr., 81549 München (DE); Mazure-Espejo, Carlos, Dr., 85604 Zorneding (DE)
(74) Vertreter: Zimmermann & Partner

(56) Entgegenhaltungen:
- EP-A- 0 725 430
- US-A- 5 238 873
- US-A- 5 500 386
- RAND M J ET AL: "Observations on the formation and etching of platinum silicide" APPLIED PHYSICS LETTERS, 15 JAN. 1974, USA, Bd. 24, Nr. 2, ISSN 0003-6951, Seiten 49-51, XP002070207
- DATABASE INSPEC INSTITUTE OF ELECTRICAL ENGINEERS, STEVENAGE, GB Inspec No. 5790173, YOO-CHAN JEON ET AL: "Thermal stability of metal electrodes (Pt, Ru, and Ir) on polycrystalline silicon in ferroelectric capacitors" XP002070208 & NINTH INTERNATIONAL SYMPOSIUM ON INTEGRATED FERROELECTRICS, SANTA FE, NM, USA, 3-5 MARCH 1997, Bd. 17, Nr. 1-4, ISSN 1058-4587, INTEGRATED FERROELECTRICS, 1997, GORDON & BREACH, NETHERLANDS, Seiten 489-500,

## Beschreibung

Die Erfindung betrifft ein Herstellverfahren für eine Kondensatorelektrode aus einem Platinmetall in einer integrierten Halbleiterschaltung.

Ein Beispiel für eine Halbleiterschaltung mit einem Kondensator ist eine DRAM-Speicherzelle. Zur Erhöhung der Integrationsdichte kann sie als sogenannte "stacked capacitor"-Zelle realisiert werden, bei der der Speicherkondensator oberhalb des zugehörigen Auswahltransistors angeordnet ist. Einen wesentlichen Einfluß auf den Platzbedarf eines solchen Kondensators hat unter anderem die Wahl des Kondensatordielektrikums.

Konventionelle Kondensatoren benutzen als Speicherdielektrikum meist Siliziumoxid- bzw. -nitridschichten, die eine Dielektrizitätskonstante von maximal 8 besitzen. Neue paraelektrische Materialien, wie beispielsweise BST (Barium-Strontium-Titanat, BaSrTiO₃) und ähnliche besitzen eine Dielektrizitätskonstante ε > 150 und ermöglichen somit einen kleineren Kondensator.

Derartige Speicherelemente mit einem paraelektrischen Material als Kondensatordielektrikum (DRAM) verlieren bei Ausfall der Versorgungsspannung ihre Ladung und somit ihre gespeicherte Information. Weiter müssen konventionelle Speicherelemente wegen des Restleckstroms ständig neu beschrieben werden (Refresh-Time). Der Einsatz eines ferroelektrischen Materials als Speicherdielektrikum erlaubt aufgrund der unterschiedlichen Polarisationsrichtungen den Bau eines nichtflüchtigen Speichers, der seine Information bei Ausfall der Versorgungsspannung nicht verliert und nicht ständig neu beschrieben werden muß. Der Restleckstrom der Zelle beeinflußt nicht das gespeicherte Signal. Eine Beispiel für ein derartiges ferroelektrisches Material ist PZT (Blei-Zirkonium-Titanat, Pb (Zr, Ti)0₃

Die Herstellung dieser neuen Ferro- und Paraelektrika erfolgt im allgemeinen bei hohen Temperaturen in einer oxidierenden Atmosphäre. Daher wird insbesondere für die erste Kondensatorelektrode ein Material benötigt, daß mit diesen Bedingungen kompatibel ist.

In den meisten Fällen wird eine Elektrode aus einem Edelmetall wie Platin, Iridium oder Ruthenium eingesetzt (allg. als "Platinmetalle" bezeichnet). Die Strukturierung von Platinmetallen, insbesondere bspw. einer relativ dicken Platinschicht, ist aber ein bislang weitgehend ungelöstes Problem, da noch kein geeigneter Ätzprozeß entwickelt wurde, und da keine flüchtigen Platin-Verbindungen für RIE-Prozesse geeignet erscheinen. Bisherige Ätzprozesse beruhen auf dem Aufbringen einer Lackmaske und Ätzen in Argon-, Sauerstoff- oder Chlorplasmen. Dabei kann wegen des hohen physikalischen Anteils des Prozesses nur eine geringe Selektivität gegenüber Maskenmaterialien und Untergrund erzielt werden.

Zum Teil wurden auch Schwefel verbindungen dem Ätzgas beigemischt, um eine höhere Selektivität zu erreichen (siehe US 5.500.386).

Aufgabe der vorliegenden Erfindung ist es, ein verbessertes Herstellverfahren für eine Kondensatorelektrode aus einem Platinmetall anzugeben. Ferner soll das Herstellverfahren in den Herstellprozeß einer DRAM-Zelle mit einem Hoch-ε-Paraelektrikum oder einem Ferroelektrikum als Speicherdielektrikum integrierbar sein.

Diese Aufgabe wird durch ein Herstellverfahren mit den Merkmalen des Patentanspruchs 1 gelöst.

Die Erfindung beruht auf dem Einsatz eines Salizid-Verfahrens (self aligned silizied) zur Herstellung der Kondensatorelektrode. Dazu wird zunächst ein Träger mit einer siliziumhaltigen Oberfläche erzeugt. Der Träger ist insbesondere ein Halbleitersubstrat, eventuell mit bereits erzeugten Schaltungselementen.

Dann wird gemäß einer Ausführungsform eine leitende Schicht abgeschieden und zu einem Elektrodenkörper strukturiert. Dieser Elektrodenkörper hat im wesentlichen die Form der zu erzeugenden Kondensatorelektrode. Außerhalb des Elektrodenkörpers liegt die a-Si-Oberfläche frei. Auf dem Elektrodenkörper wird konform eine Platinschicht abgeschieden. Durch einen Temperaturprozeß wird das Platin, das auf der Si-haltigen Oberfläche aufliegt, siliziert, d.h. in PtSiₓ umgewandelt. Das PtSiₓ wird dann selektiv geätzt, während das auf dem Elektrodenkörper vorhandene Platin nicht angegriffen wird. Ein geeignetes Ätzverfahren ist in dem Artikel M. Rand et al, Appl. Phys. Lett. 24 (1974), Seite 49 angegeben. Dabei wird in HF die schützende Oxidschicht von Platinsilizid entfernt, eine anschließende Ätzung in Königswasser ätzt das Platinsilizid schneller als das metallische Platin. Eventuell zurückbleibendes Siliziumoxid kann wiederum mit HF entfernt werden.

Ein wesentlicher Vorteil der Erfindung ist, daß kein Ätzverfahren für metallisches Platin benötigt wird. Statt dessen wird ein leichter strukturierbares leitendes Ersatzmaterial zu einem Elektrodenkörper geätzt. Die Platinschicht auf dem Elektrodenkörper ist dann selbstjustiert zu diesem, d.h. es wird keine weitere Maske dafür benötigt.

Die Si-haltige Trägeroberfläche kann eine Polysiliziumschicht sein. Vorzugsweise ist es eine a-Si-Schicht (amorphe Siliziumschicht), da sich diese zur Silizidbildung besonders gut eignet. Je nach Aufbau des Trägers ist es vorteilhaft, eine Schicht eines Ätzstopmaterials wie beispielsweise Siliziumnitrid unter der Si-Schicht an der Trägeroberfläche vorzusehen. Dadurch wird der darunterliegende Teil des Trägers bei der späteren Silizidätzung geschützt.

Die siliziumhaltige Oberfläche muß eventuell durch eine dünne Oxidschicht, die beispielsweise durch eine Oxidation erzeugt wird, während der folgenden Prozesse geschützt werden (beispielsweise während der Herstellung des Elektrodenkörpers). Diese dünne Oxidschicht wird später, insbesondere vor der Platinabscheidung, wieder entfernt.

Zum Anschluß der Elektrode ist beispielsweise vorgesehen, ggf. nach Herstellung der Si-Schicht bzw. der eventuellen Oxidschutzschicht ein Kontaktloch in den Träger und ggf. in diese Schichten zu einer unterliegenden leitfähigen Struktur zu ätzen. Bei einer DRAM-Speicherzelle kann so der Anschluß zum Source/Drain-Gebiet des zugehörigen Auswahltransistors erzeugt werden.

Weist die Speicherzelle als Speicherdielektrikum ein hoch-ε-Dielektrikum oder ein Ferroelektrikum auf, muß zwischen diesem und der nächsten tieferliegenden oxidierbaren Struktur eine Sauerstoffdiffusionsbarriere angeordnet werden, damit der Kontakt zum S/D-Gebiet nicht durch eine Oxidation verschlechtert wird. Dazu kann der Elektrodenkörper und/oder eine Anschlußstruktur, die das Kontaktloch auffüllt, aus einem leitenden Sauerstoffbarrierenmaterial bestehen. Es ist aber auch möglich, diese beiden Strukturen aus beispielsweise Polysilizium oder Wolfram herzustellen und eine Barriere selbstjustiert auf dem Elektrodenkörper zu bilden, beispielsweise durch Abscheidung oder durch einen Temperaturprozeß.

Die Erfindung wird im folgenden anhand von Ausführungsbeispielen, die in den Zeichnungen dargestellt sind, näher erläutert. Es zeigen
- FIG 1 bis 3: einen schematischen Querschnitt durch eine Halbleiteranordnung, an dem ein erstes Ausführungsbeispiel des Verfahrens verdeutlicht wird,
- FIG 4 bis 11: weitere Ausführungsbeispiele.

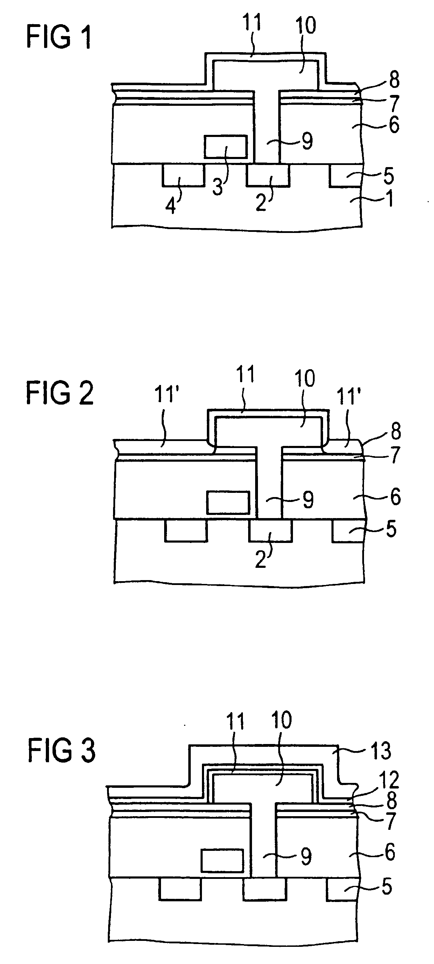

FIG 1: Das Verfahren wird am Beispiel einer DRAM-Speicherzelle erläutert. In einem Silizium-Halbleitersubstrat 1 ist ein MOS-Transistor mit dotierten Gebieten 2, 4 (Source/Drain) und einem Gate 3 hergestellt, der durch ein Isolationsgebiet 5 von dem Transistor einer benachbarten Speicherzelle getrennt ist. Die Anordnung ist mit einer Isolationsschicht 6, z.B. Siliziumoxid, abgedeckt. Auf dieser Oberfläche werden eine etwa 150 nm dicke Schicht Si₃N₄ als Ätzstopmaterial 7 und eine Schicht amorphes Silizium 8 mit bekannten Verfahren abgeschieden. Auf diese Weise ist der Träger für die Kondensatorelektrode gebildet. Die Dicke der a-Si-Schicht beträgt vorzugsweise weniger als 200 nm, bspw. 100 nm, um die später notwendige PtSi-Ätzung kurz zu halten. Das amorphe Silizium 8 muß eventuell durch eine dünne Oxidschicht (nicht dargestellt), die später wieder entfernt wird, während der nächsten Schritte (insbes. während der Strukturierung des Elektrodenkörpers) geschützt werden. Mit Hilfe einer Fototechnik wird ein Kontaktloch bis zum S/D-Gebiet 2 geätzt. In dieses Kontaktloch wird nun eine leitende Anschlußstruktur 9 eingebracht. Dazu wird in einer ersten Ausführungsform ein leitendes Barrierenmaterial zur Verhinderung von Sauerstoffdiffusion ganzflächig aufgebracht, so daß das Kontaktloch aufgefüllt wird und die Oberfläche der Anordnung bedeckt ist. Beispielsweise kann bei einem Kontaktloch mit 0,8 µ Durchmesser eine etwa 500 nm dicke Wolframnitrid-Schicht mit bekannten Verfahren (z.B. CVD) abgeschieden werden. Diese WN-Schicht wird strukturiert, so daß ein über der Anschlußstruktur 9 angeordneter Elektrodenkörper 10 entsteht. Außerhalb des Elektrodenkörpers wird die a-Si-Oberfläche freigelegt. Auf die nun vorhandene Oberfläche wird ganzflächig Platin 11 abgeschieden (Dicke etwa 100 nm).

FIG 2: Durch einen Temperaturschritt wird lediglich das auf dem aSi liegende Platin siliziert, während auf dem Elektrodenkörper 10 metallisches Platin 11 bleibt. Der Temperaturschritt kann als RTP (Rapid Thermal Processing) in Stickstoff (1 min bei 500°C) durchgeführt werden oder auch als Ofenprozeß in Stickstoff oder Argon. Das entstandene Platinsilizid 11' wird dann mit einem geeigneten Naßätzverfahren, wie oben erläutert, entfernt.

FIG 3: Um den Speicherkondensator fertigzustellen, wird ein Kondensatordielektrikum 12, vorzugsweise ein hoch-ε-Dielektrikum ganzflächig aufgebracht. Im Fall eines FRAM wird statt dessen ein Ferroelektrikum abgeschieden. Da der Elektrodenkörper 10 und die Anschlußstruktur 9 aus einer Sauerstoffdiffusionsbarriere gebildet sind, werden tieferliegende Strukturen dabei nicht oxidiert. Dann wird die obere Elektrode 13 beispielsweise ebenfalls aus Platin hergestellt.

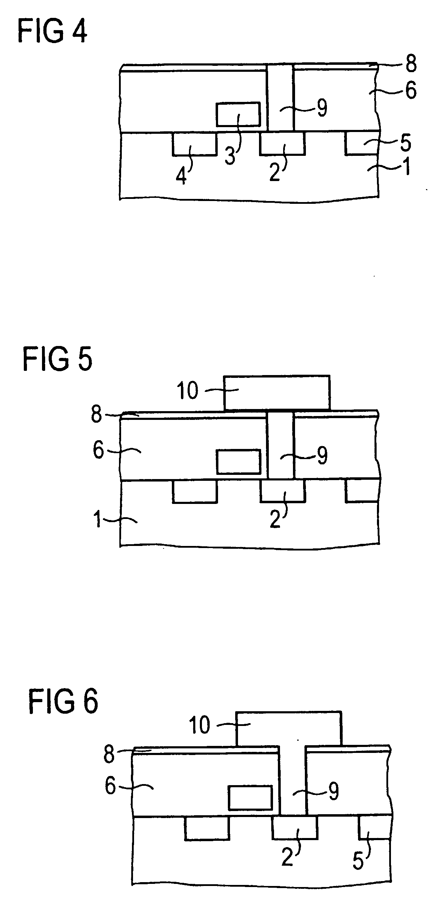

Die folgenden Ausführungsbeispiele (Fig. 4 bis 9) unterscheiden sich nur in der Herstellung von Anschlußstrukturen 9, Elektrodenkörper 10 sowie ggf. einer Sauerstoffdiffusionsbarriere vom ersten Ausführungsbeispiel, so daß nur diese Schritte anhand der Figuren erläutert werden:

FIG 4 bis 5: In das geätzte Kontaktloch wird zur Herstellung der Anschlußstruktur 9 eine leitende Schicht, beispielsweise Polysilizium oder Wolfram, eingebracht, vorzugsweise durch ganzflächige Abscheidung und anschließende Rückätzung bis zur Oberkante des Kontaktloch. Dann wird ganzflächig eine Sauerstoffdiffusionsbarriere abgeschieden und zum Elektrodenkörper 10 strukturiert.

FIG 6 bis 7: Nach Herstellung des Kontaktlochs wird Wolfram ganzflächig abgeschieden und strukturiert, so daß die Anschlußstruktur 9 und der Elektrodenkörper 10 gebildet werden. Eine Sauerstoffdiffusionsbarriere 14, die auf dem Elektrodenkörper angeordnet ist, kann durch Rapid Thermal Processing (RTP) in einer stickstoffhaltigen Atmosphäre hergestellt werden, wodurch sich eine WN-Schicht 14 selbstjustiert auf der freiliegenden Oberfläche des Elektrodenkörpers 10 bildet.

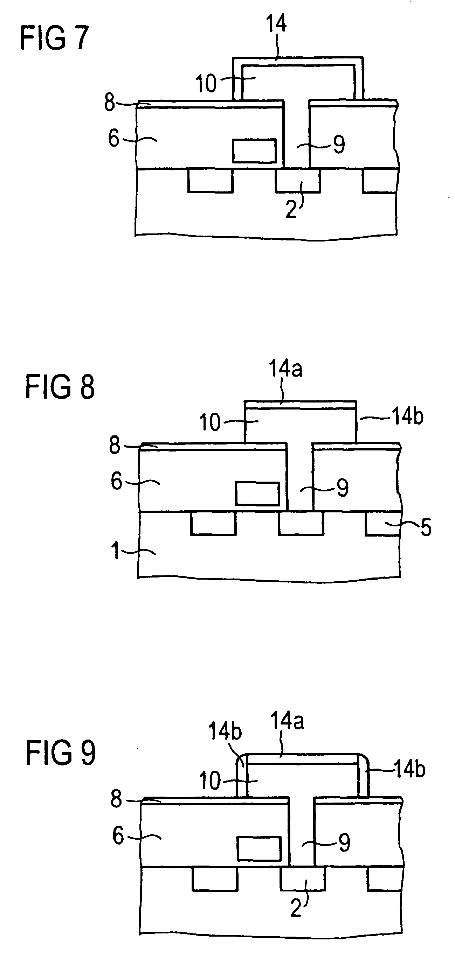

FIG 8 bis 9: Im vierten Ausführungsbeispiel wird nach Herstellung des Kontaktlochs ganzflächig beispielsweise Polysilizium oder Wolfram abgeschieden. Darauf wird z.B. WN als Sauerstoffbarriere 14a abgeschieden. Diese Doppelschicht 10, 14 wird strukturiert, so daß ein Elektrodenkörper 10 gebildet wird, dessen Oberseite bereits mit einer Sauerstoffbarriere 14a bedeckt ist. An der übrigen freiliegenden Oberfläche, d.h. an den Seitenwänden des Elektrodenkörpers 10 wird mit Hilfe einer Spacertechnik ebenfalls eine Barriere 14b aus WN erzeugt (d.h. durch eine ganzflächige Abscheidung mit anschließender anisotroper Rückätzung des Barrierenmaterials).

Das weitere Verfahren bei diesem Ausführungsbeispiel wird wie im ersten Beispiel durchgeführt, also Platinabscheidung, Silizierung usw.

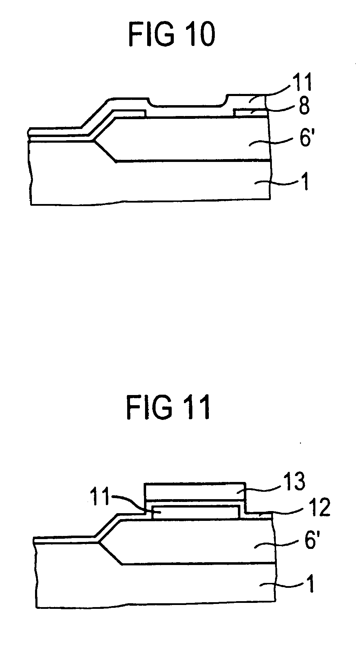

FIG 10 bis 11: Mit dem Verfahren kann auch der Speicherkondensator bei einer sogenannten "top-contact"-Zelle hergestellt werden. Bei einer solchen, in der Figur dargestellten Zelle ist die untere Kondensatorelektrode mit ihrer gesamten Fläche auf einem Isolationsmaterial, beispielsweise LOCOS angeordnet. Der elektrische Kontakt zum zugehörigen Auswahltransistor wird erst nach der Herstellung des gesamten Kondensators mit Hilfe der ersten Verdrahtungsebene der Schaltung hergestellt. Die Speicherzelle benötigt zwar mehr Fläche, ist aber einfacher herstellbar, beispielsweise kann in den meisten Fällen auf eine Sauerstoffbarriere verzichtet werden. Das Herstellverfahren unterscheidet sich von dem zuvor beschriebenen grundlegenden Verfahren dadurch, daß die Kondensatorelektrode nicht durch einen Elektrodenkörper, der die Silizium-haltige Oberfläche bedeckt, definiert wird, sondern durch das Ätzen einer Öffnung in eine Siliziumschicht definiert wird. Der in der Figur dargestellte Kondensator, bei dem dieselben Bezugsziffern wie in den bisherigen Ausführungsbeispielen verwendet wurden, läßt sich beispielsweise folgendermaßen herstellen:

Auf die Isolationsschicht 6' (dies kann insbesondere auch ein Isolationsgebiet sein, daß der Isolation benachbarter Zellen dient) wird eine amorphe oder polykristalline Siliziumschicht 8 abgeschieden. In diese Siliziumschicht 8 wird nun eine Öffnung bis zur unterliegenden Isolationsschicht geätzt. Diese Öffnung definiert die lateralen Ausmaße der herzustellenden Elektrode, da innerhalb der Öffnung kein Silizid gebildet werden kann. Die Öffnung hat also dieselbe Funktion wie der in den bisherigen Ausführungsbeispielen hergestellte Elektrodenkörper. Das weitere Verfahren ist wie eingangs beschrieben (Abscheiden von Platin oder eines Platinmetalls, Silizidbildung, selektives Entfernen des Silizides und Fertigstellung des Kondensators). Der Prozeß führt also zu Platin-Inseln in der Öffnung der Siliziumschicht 8.

## Patentansprüche

1. Herstellverfahren für eine Kondensatorelektrode aus einem Platinmetall in einer integrierten Halbleiterschaltung mit folgenden Schritten:
- Herstellen eines Trägers für die Kondensatorelektrode mit einer Silizium-haltigen Oberfläche,
- Herstellen eines leitenden Elektrodenkörpers (10) auf der siliziumhaltigen Oberfläche, der im wesentlichen die geometrische Form der zu erzeugenden Kondensatorelektrode besitzt, so daß benachbart zum Elektrodenkörper (10) die siliziumhaltige Oberfläche freiliegt,
- Abscheiden einer Schicht aus einem Platinmetall (11),
- Durchführen eines Temperaturschrittes, so daß der auf der siliziumhaltigen Oberfläche aufliegende Bereich der Platinmetallschicht siliziert wird,
- Entfernen des Platinmetallsilizids (11').

2. Herstellverfahren nach Anspruch 1, bei dem von dem Herstellverfahren des Elektrodenkörpers (10) ein Kontaktloch zur Aufnahme einer Anschlußstruktur (9) in den Träger bis zu einer tieferliegenden leitenden Struktur (2) geätzt wird.

3. Herstellverfahren nach einem der Ansprüche 1 bis 2, bei dem das Herstellen des Trägers das Aufbringen einer Siliziumschicht (8) als oberster Schicht umfaßt.

4. Herstellverfahren nach Anspruch 3, bei dem auf der Siliziumschicht (8) eine Siliziumoxidschicht als Schutzschicht erzeugt wird.

5. Herstellverfahren nach einem der Ansprüche 3 bis 4, bei dem unterhalb der Siliziumschicht (8) eine Ätzstopschicht (7) auf den Träger aufgebracht wird.

6. Herstellverfahren nach einem der Ansprüche 1 bis 5, bei dem eine Barrierenschicht (9, 10, 14) zur Verhinderung von Sauerstoffdiffusion vor dem Abscheiden der Platinmetallschicht (11) hergestellt wird.

7. Herstellverfahren nach einem der Ansprüche 1 bis 6, bei dem nach Herstellen des Kontaktlochs ganzflächig eine Barrierenschicht abgeschieden wird, aus der die Anschlußstruktur (9) und der Elektrodenkörper (10) gebildet werden.

8. Herstellverfahren nach einem der Ansprüche 2 bis 6, bei dem nach Herstellen des Kontaktlochs ganzflächig eine leitende Schicht aufgebracht und zur Anschlußstruktur (9) rückgeätzt wird und bei dem dann eine Barrierenschicht ganzflächig aufgebracht und zum Elektrodenkörper (10) strukturiert wird.

9. Herstellverfahren nach einem der Ansprüche 2 bis 6, bei dem nach Herstellen des Kontaktlochs ganzflächig eine leitende Schicht aufgebracht wird, aus der die Anschlußstruktur (9) und der Elektrodenkörper (10) gebildet werden und bei dem dann durch einen Temperaturprozeß auf der freiliegenden Oberfläche des Elektrodenkörpers eine Sauerstoffbarriere gebildet wird.

10. Herstellverfahren nach einem der Ansprüche 2 bis 6, bei dem eine Sauerstoffdiffusionsbarriere (14b) an den Seitenwänden des Elektrodenkörpers (10) durch eine Spacertechnik hergestellt wird.

11. Herstellverfahren für eine Kondensatorelektrode aus einem Platinmetall in einer integrierten Halbleiterschaltung mit folgenden Schritten:
- Herstellen eines Trägers (1) mit einer isolierenden Schicht (6') und Aufbringen einer Siliziumschicht (8) auf der isolierenden Schicht (6')
- Erzeugen einer Öffnung in der Siliziumschicht (8), die im wesentlichen die lateralen Ausmaße wie die zu erzeugende Kondensatorelektrode hat,
- Abscheiden einer Schicht aus einem Platinmetall (11),
- Durchführen eines Temperaturschrittes, so daß der auf der Siliziumschicht (8) aufliegende Bereich der Platinmetallschicht (11) siliziert wird,
- Entfernen des Platinmetallsilizids.

12. Herstellverfahren nach einem der Ansprüche 1 bis 11, bei dem im Anschluß ein Ferroelektrikum oder ein Paraelektrikum (12) auf der erzeugten Kondensatorelektrode und darauf eine zweite Kondensatorelektrode (13) aufgebracht werden.

13. Herstellverfahren nach einem der Ansprüche 1 bis 12, bei dem als Platinmetall Platin verwendet wird.

14. Verwendung des Verfahrens gemäß Ansprüche 1-13 bei der Herstellung einer Speicherzelle.

## Claims

1. Method for producing a capacitor electrode from a platinum metal in an integrated semiconductor circuit, having the following steps:
- producing a support for the capacitor electrode with a silicon-containing surface,
- producing a conducting electrode body (10) on the silicon-containing surface which has substantially the geometrical shape of the capacitor electrode to be produced, so that the silicon-containing surface is exposed in the vicinity of the electrode body (10),
- depositing a layer made from a platinum metal (11),
- carrying out a temperature step such that the region of the platinum metal layer resting on the silicon-containing surface is silicided,
- removing the platinum metal silicide (11').

2. Production method according to Claim 1, in which the method for producing the electrode body (10) etches a contact hole for holding a lead structure (9) in the support as far as a lower-lying conducting structure (2).

3. Production method according to one of Claims 1 to 2, in which the production of the support comprises applying a silicon layer (8) as uppermost layer.

4. Production method according to Claim 3, in which a silicon oxide layer is produced as protective layer on the silicon layer (8).

5. Production method according to one of Claims 3 to 4, in which an etch stop layer (7) is applied to the support below the silicon layer (8).

6. Production method according to one of Claims 1 to 5, in which a barrier layer (9, 10, 14) for preventing oxygen diffusion is produced before the deposition of the platinum metal layer (11).

7. Production method according to one of Claims 1 to 6, in which after the production of the contact hole a barrier layer from which the lead structure (9) and the electrode body (10) are formed is deposited over the entire surface.

8. Production method according to one of Claims 2 to 6, in which after production of the contact hole a conducting layer is applied over the entire surface and back-etched to the lead structure (9), and in which a barrier layer is then applied over the entire surface and structured to form an electrode body (10).

9. Production method according to one of Claims 2 to 6, in which after production of the contact hole a conducting layer from which the lead structure (9) and the electrode body (10) are formed is applied over the entire surface, and in which an oxygen barrier is then formed by a temperature process on the exposed surface of the electrode body.

10. Production method according to one of Claims 2 to 6, in which an oxygen diffusion barrier (14b) is produced on the side walls of the electrode body (10) by means of a spacer technique.

11. Method for producing a capacitor electrode from a platinum metal in an integrated semiconductor circuit, having the following steps:
- producing a support (1) with an insulating layer (6'), and applying a silicon layer (8) on the insulating layer (6'),
- producing an opening in the silicon layer (8) which has substantially the lateral dimensions of the capacitor electrode to be produced,
- depositing a layer made from a platinum metal (11),
- carrying out a temperature step such that the region of the platinum metal layer (11) resting on the silicon layer (8) is silicided,
- removing the platinum metal silicide.

12. Production method as claimed in one of Claims 1 to 11, in which subsequently a ferroelectric or paraelectric (12) is applied to the capacitor electrode produced, and a second capacitor electrode (13) is applied thereon.

13. Production method according to one of Claims 1 to 12, in which platinum is used as platinum metal.

14. Use of the method according to Claims 1-13 in the production of a memory cell.

## Revendications

1. Procédé de production d'une électrode de condensateur en un métal de la mine du platine dans un circuit à semi-conducteur intégré ayant des stades suivants :
- on produit un support pour l'électrode de condensateur ayant une surface contenant du silicium,
- on produit sur la surface contenant du silicium un corps (10) d'électrode conducteur, qui a sensiblement la forme géométrique de l'électrode de condensateur à produire, de façon à ce que la surface contenant du silicium soit à nu au voisinage du corps (10) d'électrode,
- on dépose une couche d'un métal (11) de la mine du platine,
- on effectue un stade thermique de façon à silicier la partie de la couche de métal du platine qui est appliquée à la surface contenant du silicium,
- on élimine le siliciure (11') du métal de la mine du platine.

2. Procédé de production suivant la revendication 1, dans lequel on ménage par attaque par le procédé de production du corps (10) d'électrode un trou de contact de réception d'une structure (9) de connexion dans le support jusqu'à une structure (2) conductrice sous-jacente.

3. Procédé de production suivant l'une des revendications 1 à 2, dans lequel la production du support comprend le dépôt d'une couche (8) de silicium comme couche la plus haute.

4. Procédé de production suivant la revendication 3, dans lequel on produit comme couche de protection une couche d'oxyde de silicium sur la couche (8) de silicium.

5. Procédé de production suivant l'une des revendications 3 à 4, dans lequel on dépose sur le support une couche (7) d'arrêt d'attaque en dessous de la couche (8) de silicium.

6. Procédé de production suivant l'une des revendications 1 à 5, dans lequel on produit une couche (9, 10, 14) barrière pour empêcher une diffusion d'oxygène avant le dépôt de la couche (11) du métal de la mine du platine.

7. Procédé de production suivant l'une des revendications 1 à 6, dans lequel on dépose après la production du trou de contact sur toute la surface une couche barrière à partir de laquelle on forme la structure (9) de connexion et le corps (10) d'électrode.

8. Procédé de production suivant l'une des revendications 2 à 6, dans lequel, après la production du trou de contact, on dépose sur toute la surface une couche conductrice et on l'attaque en retrait pour la structure (9) de connexion et dans lequel on dépose ensuite sur toute la surface une couche barrière et on la structure en le corps (10) d'électrode.

9. Procédé de production suivant l'une des revendications 2 à 6, dans lequel, après la production du trou de contact, on dépose sur toute la surface une couche conductrice à partir de laquelle on forme la structure (9) conductrice et le corps (10) d'électrode et dans lequel on forme ensuite par un processus thermique une barrière à l'oxygène sur la surface mise à nu du corps d'électrode.

10. Procédé de production suivant l'une des revendications 2 à 6, dans lequel on produit une barrière (14b) de diffusion de l'oxygène sur les deux parois latérales du corps (10) d'électrode par une technique d'espaceur.

11. Procédé de production d'une électrode de condensateur en un métal de la mine du platine dans un circuit à semi-conducteur intégré ayant des stades suivants :
- on produit un support (1) ayant une couche (6') isolante et on dépose une couche (8) de silicium sur la couche (6') isolante,
- on ménage une ouverture dans la couche (8) de silicium qui a sensiblement la dimension latérale de l'électrode de condensateur à produire,
- on dépose une couche en un métal (11) de la mine du platine,
- on effectue un stade thermique de façon à silicier la partie de la couche (11) du métal de la mine du platine se trouvant sur la couche (18) de silicium,
- on élimine le siliciure du métal de la mine du platine.

12. Procédé de production suivant l'une des revendications 1 à 11, dans lequel on dépose ensuite un ferroélectrique ou un paraélectrique (12) sur l'électrode de condensateur produite et ensuite une deuxième électrode (13) de condensateur.

13. Procédé de production suivant l'une des revendications 1 à 12, dans lequel on utilise du platine comme métal de la mine du platine.

14. Utilisation du procédé suivant les revendications 1 à 13 dans la production d'une cellule de mémoire.
